(19) Europäisches Patentamt
European Patent Office
Office européen des brevets

(11) **EP 2 284 121 B1**

(12) **FASCICULE DE BREVET EUROPEEN**

(45) Date de publication et mention
de la délivrance du brevet:
**07.10.2015 Bulletin 2015/41**

(51) Int Cl.:
***B81C 1/00*** *(2006.01)*

(21) Numéro de dépôt: **10171427.7**

(22) Date de dépôt: **30.07.2010**

(54) **Structure à microcavité et structure d'encapsulation d'un dispositif microélectronique**

Hohlraum für ein mikromechanisches Bauelement

Microcavity encapsulation structure for a microelectronic component

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**

(30) Priorité: **06.08.2009 FR 0955537**

(43) Date de publication de la demande:
**16.02.2011 Bulletin 2011/07**

(73) Titulaire: **Commissariat à l'Énergie Atomique et aux Énergies Alternatives 75015 Paris (FR)**

(72) Inventeurs:
• **Baillin, Xavier**
**38920, CROLLES (FR)**
• **Caplet, Stéphane**
**38360, SASSENAGE (FR)**
• **Hilt, Thierry**
**38530, BARRAUX (FR)**

(74) Mandataire: **Ilgart, Jean-Christophe BREVALEX 95, rue d'Amsterdam 75378 Paris Cedex 8 (FR)**

(56) Documents cités:
WO-A1-2007/074017      US-A- 6 032 923
US-A1- 2009 090 531

**Description**

**DOMAINE TECHNIQUE**

L'invention se rapporte au domaine de la microélectronique, et plus particulièrement à celui des structures à microcavités utilisées par exemple pour réaliser un packaging, ou une encapsulation, de dispositifs microélectroniques par exemple de type MEMS (microsystèmes électromécaniques) et/ou NEMS (nanosystèmes électromécaniques) et/ou MOEMS (microsystèmes opto-électromécaniques) et/ou NOEMS (nanosystèmes opto-électromécaniques), pour les protéger de l'environnement extérieur.

**ÉTAT DE LA TECHNIQUE ANTÉRIEURE**

Un premier type de procédé d'encapsulation de dispositifs microélectroniques consiste à réaliser un report d'un capot, formé par un substrat, sur le support sur lequel sont réalisés les dispositifs. Ce type de procédé d'encapsulation nécessite de réaliser un usinage d'un capot préalablement à son assemblage avec le support. Afin de contrôler l'atmosphère régnant dans la microcavité, il est nécessaire de réaliser à la fois un scellement hermétique entre le support et le capot, mais également de déposer un getter en couche mince sur le capot, généralement au fond d'un creux préalablement usiné dans le capot. Les trois modes de scellement hermétique les plus utilisés dans le domaine des microtechnologies sont les scellements métalliques eutectiques, directs et anodiques. Un scellement anodique ne s'applique qu'au seul cas d'un assemblage entre un capot en verre et un support en silicium.

Toutefois, avec ce type de procédé d'encapsulation, même assisté par un getter disposé dans la microcavité, il est difficile d'atteindre dans la microcavité une pression inférieure à environ $10^{-3}$ mbar et donc de contrôler l'atmosphère résiduelle dans la microcavité dans laquelle est encapsulé le dispositif microélectronique.

Un second type de procédé d'encapsulation appelé « Packaging en couche mince », ou PCM, d'un dispositif microélectronique consiste à créer une structure d'encapsulation autour du dispositif lui-même préalablement disposé sur un substrat. Ce type de procédé est généralement réalisé de manière collective pour plusieurs dispositifs microélectroniques disposés sur un même substrat et par la mise en oeuvre de techniques conventionnelles utilisées dans le domaine de la microélectronique.

Aujourd'hui, la filière la plus développée pour réaliser une encapsulation de type PCM consiste à déposer une résine sacrificielle photosensible sur les dispositifs microélectroniques, de la soumettre à une opération technologique de photolithographie puis à un traitement thermique de mise en forme, et enfin à déposer une couche d'encapsulation en un matériau hermétique, par exemple un oxyde, sur la résine pour former le capot. Des trous de libération sont ensuite percés à travers le capot pour former des accès servant à graver la résine sacrificielle. Les trous de libération doivent ensuite être bouchés pour fermer la cavité. C'est pour cela qu'ils sont de très petites dimensions, et que leurs emplacements et leur nombre sont imposés par le dispositif microélectronique lui-même qui ne doit pas être situé à l'aplomb de ces trous en raison de l'obturation des trous réalisée par la suite afin de fermer la cavité. Toutefois, même lorsque le dispositif micro-électronique n'est pas situé à l'aplomb des trous, il existe tout de même un risque d'endommagement du dispositif ou d'altération de son bon fonctionnement en raison du matériau de bouchage des trous qui peut venir polluer l'intérieur de la cavité et/ou le dispositif lui-même lors du bouchage des trous.

Le document EP 1 708 958 B1 décrit un procédé de réalisation d'une microcavité hermétique dans laquelle est encapsulé un microcomposant. Dans ce procédé, la cavité est fermée en bouchant des orifices de libération réalisés à travers le capot par des bouchons externes. Les bouchons sont à base d'un matériau susceptible de se déformer par fluage. Les dimensions des orifices de libération, correspondant par exemple au diamètre ou aux dimensions des côtés selon la forme des sections des orifices, sont inférieures à environ 5 $\mu$m. Ces bouchons sont à base d'un matériau polymérisé afin d'éviter que le matériau formant le bouchon ne rentre à l'intérieur de la cavité lors du dépôt du matériau sur le capot. Ainsi, en plus de la difficulté de contrôler l'atmosphère résiduelle de la cavité après la réalisation de ces bouchons, ce procédé ne permet pas de réaliser des orifices de libération de dimensions supérieures à environ 5 $\mu$m ni d'utiliser des matériaux autres qu'un matériau polymérisé pour boucher les orifices de libération.

Le document EP 1 694 597 B1 décrit un procédé de réalisation d'une microcavité hermétique dans laquelle est encapsulé un microcomposant. La microcavité peut être fermée depuis l'extérieur par une couche externe sous contrainte mécanique en tension fléchissant en direction de la microcavité. Une autre couche externe sous contrainte mécanique en compression peut être disposée au-dessus de la première couche afin de maintenir la microcavité ouverte lors de la libération du microcomposant. Dans une autre variante, la microcavité peut également être fermée par une première couche externe non contrainte ou faiblement contrainte en compression et recouverte, après la libération du microcomposant, par une seconde couche sous contrainte mécanique en tension.

Lorsque la microcavité est fermée par deux couches sous contraintes mécaniques différentes, l'équilibre des contraintes mécaniques entre les deux couches doit être parfaitement ajusté. Or, un tel ajustement est difficile à réaliser. De plus, dans le cas où une seule couche externe sous contrainte mécanique en tension est utilisée pour fermer la microcavité, la durée de libération du microcomposant (correspondant à la gravure du matériau sacrificiel se trouvant dans la microcavité) est alors très longue. Enfin, l'ajout d'une seconde couche externe après la libération du microcomposant représente également une contrainte importante.

Le document US 2009 /0090531 A1 décrit un procédé de réalisation d'une microcavité hermétique dans laquelle est encapsulé un microcomposant.

Dans ce procédé, la cavité est fermée en bouchant un orifice de libération dans le capot par une membrane flexible ancré sur la surface intérieur de la cavité. Le membrane est actué en utilisant une force électrostatique.

**EXPOSÉ DE L'INVENTION**

Un but de la présente invention est de proposer une structure à microcavité permettant de réaliser une encapsulation d'au moins un dispositif microélectronique, et qui ne présente par les inconvénients de l'art antérieur.

Pour cela, la présente invention propose une structure à microcavité comportant au moins :

- un substrat,
- un capot solidarisé au substrat tel qu'un espace formé entre le capot et le substrat forme la microcavité,
- au moins un trou traversant le capot, et
- au moins un clapet d'obturation du trou comprenant au moins deux portions de matériaux de coefficients de dilatation thermique différents disposées l'une contre l'autre, au moins une première extrémité desdites deux portions étant reliée mécaniquement au capot, au moins une seconde extrémité desdites deux portions étant libre, et au moins une partie du clapet d'obturation étant disposée en regard du trou. Lesdites deux portions peuvent être aptes à obturer ou non le trou sous l'effet d'une variation de température.

Une telle structure comporte donc au moins un clapet d'obturation dont au moins une partie est disposée à l'aplomb, ou en regard, d'un ou plusieurs trous de libération, et dont le fonctionnement, c'est-à-dire le passage d'une première position dans laquelle le clapet n'obture pas le ou les trous à une seconde position dans laquelle ladite partie du clapet, disposée en regard du ou des trou, obture le ou les trous est obtenu par un effet bilame : sous l'effet d'une variation de température, les deux portions de matériaux de coefficients de dilatation thermique différents se déforment pour venir obturer ou non le ou les trous. Il est ainsi possible d'accéder à l'intérieur de la microcavité lorsque le clapet est dans une position n'obturant pas le ou les trous, par exemple lorsque le clapet est soumis à une certaine température, mais également d'obturer le ou les trous, par exemple hermétiquement, lorsque le clapet est soumis à une autre température (par exemple à température ambiante), ce qui permet de réaliser le bouchage du ou des trous sans polluer l'intérieur de la microcavité par le matériau de bouchage.

Compte tenu de la présence du clapet d'obturation, les dimensions du ou des trous formés à travers le capot peuvent être beaucoup plus importantes que celles des trous réalisées dans les capots des structures d'encapsulation de l'art antérieur car il n'y a pas de limitation sur les matériaux de bouchage qui peuvent être utilisés pour boucher le ou les trous. Ainsi, lorsque l'on réalise une encapsulation d'un dispositif microélectronique dans une telle structure, les trous de libération peuvent être disposés de façon à réduire grandement le temps de libération du dispositif, notamment en les disposant sur toute la surface du capot, y compris à l'aplomb du dispositif, leur bouchage étant assuré par un ou plusieurs clapets d'obturation. De plus, il est possible que le clapet d'obturation soit disposé à l'aplomb, ou regard, de plusieurs trous et que le clapet d'obturation soit apte à obturer plusieurs trous simultanément. Le nombre de trous et/ou le nombre de clapets peuvent notamment être choisis en fonction des dimensions de la microcavité.

Une telle structure permet donc d'encapsuler un ou plusieurs dispositifs microélectroniques tout en évitant à la fois de polluer l'intérieur de la microcavité lors d'un bouchage du trou, mais aussi de contrôler l'atmosphère finale dans la microcavité fermée. Cette structure à microcavité est donc particulièrement adaptée pour une encapsulation de microsystèmes mécaniques résonnants, mais aussi des microsystèmes optiques sensibles à l'atmosphère dans laquelle sont placés les microsystèmes. Cette structure permet en outre d'obtenir, une fois la microcavité fermée, une pression inférieure à $10^{-3}$ mbar et par exemple de l'ordre de $10^{-4}$ à $10^{-5}$ mbar.

Le capot peut comporter un second substrat scellé directement, ou par l'intermédiaire d'un cordon de scellement, à l'autre substrat appelé premier substrat.

Dans une variante, le capot peut comporter une couche de matériau d'épaisseur comprise entre environ 1 $\mu$m et 10 $\mu$m.

Les dimensions du trou peuvent être comprises entre environ 1 $\mu$m et 100 $\mu$m.

Le clapet d'obturation peut être disposé à l'intérieur de la microcavité.

Au moins une desdites deux portions de matériaux de coefficients de dilatation thermique différents peut être à base d'un matériau getter, par exemple du titane et/ou du zirconium.

Le clapet d'obturation peut comporter au moins trois portions de matériaux de coefficients de dilatation thermique différents, la valeur du coefficient de dilatation de thermique du matériau de la portion disposée entre les deux autres pouvant être comprise entre les valeurs des coefficients de dilatation thermique des matériaux desdites deux autres portions de matériaux. Ainsi, la portion intermédiaire se trouvant entre les deux autres portions de matériaux du clapet permet de réduire les contraintes de cisaillement dans le clapet d'obturation lors d'une déformation du clapet entre une position de non obturation du trou et une position d'obturation du trou (ou inversement), notamment lorsque la différence entre les coefficients de dilatation thermique des matériaux desdites deux autres portions est supérieure ou égale à environ 15.10$^{-6}$ °C$^{-1}$.

Lesdites au moins deux portions de matériaux de coefficients de dilatation thermique différents peuvent former plusieurs éléments déformables, au moins une première extrémité de chaque élément déformable pouvant être reliée mécaniquement au capot par l'intermédiaire d'au moins un élément non déformable, au moins une seconde extrémité de chaque élément déformable pouvant être libre, et au moins une partie de chaque élément déformable pouvant être disposée en regard d'au moins un trou traversant le capot. L'élément non déformable peut donc former une armature qui permet en outre d'augmenter la résistance mécanique du capot.

La structure peut comporter en outre au moins un contact électrique traversant le capot et relié électriquement au clapet d'obturation.

La structure peut comporter en outre au moins un contact électrique traversant la microcavité depuis le substrat jusqu'au capot.

La structure peut comporter en outre au moins un bouchon bouchant le trou.

La présente invention concerne également une structure d'encapsulation d'un dispositif microélectronique, dans laquelle le dispositif microélectronique est disposé dans la microcavité d'une structure telle que décrite précédemment.

La présente invention concerne également un procédé de réalisation d'une structure à microcavité, comportant au moins les étapes de :

- réalisation d'une portion de matériau sacrificiel sur un second substrat,
- réalisation d'au moins deux portions de matériaux de coefficients de dilatation thermique différents disposées l'une contre l'autre et en partie sur la portion de matériau sacrificiel telles qu'au moins une première extrémité desdites deux portions soit disposée sur le second substrat et au moins une seconde extrémité desdites deux portions soit disposée sur la portion de matériau sacrificiel,
- solidarisation du second substrat à un premier substrat telle qu'un espace entre le second substrat et le premier substrat forme la microcavité,
- réalisation d'au moins un trou à travers le second substrat, formant un accès à la portion de matériau sacrificiel,
- élimination de la portion de matériau sacrificiel à travers le trou, lesdites deux portions de matériaux de coefficients de dilatation thermique différents formant un clapet d'obturation du trou.

Lesdites deux portions peuvent être aptes à obturer ou non le trou sous l'effet d'une variation de température.

La présente invention concerne également un procédé de réalisation d'une structure à microcavité, comportant au moins les étapes de :

- dépôt d'une couche de matériau sacrificiel sur un substrat,
- mise en forme de la couche de matériau sacrificiel,
- réalisation d'au moins deux portions de matériaux de coefficients de dilatation thermique différents disposées l'une contre l'autre sur la couche de matériau sacrificiel,
- réalisation d'une portion de matériau sacrificiel disposée en partie sur lesdites deux portions de matériaux de coefficients de dilatation thermique différents et sur la couche de matériau sacrificiel,
- dépôt d'une couche capot recouvrant la couche de matériau sacrificiel, lesdites deux portions de matériaux de coefficients de dilatation thermique différents et la portion de matériau sacrificiel ;
- réalisation d'au moins un trou à travers la couche capot, formant un accès à la portion de matériau sacrificiel ;
- élimination de la portion et de la couche de matériau sacrificiel à travers le trou, formant la microcavité, lesdites deux portions de matériaux de coefficients de dilatation thermique différents formant un clapet d'obturation du trou.

Lesdites deux portions peuvent être aptes à obturer ou non le trou sous l'effet d'une variation de température.

L'étape d'élimination de la portion de matériau sacrificiel, ou de la portion et de la couche de matériau sacrificiel, peut être mise en oeuvre à une température telle que le clapet d'obturation puisse être déformé dans une position n'obturant pas le trou.

Le procédé peut comporter en outre, après l'étape d'élimination de la portion de matériau sacrificiel, ou de la portion et de la couche de matériau sacrificiel, une étape de bouchage de la microcavité par la réalisation d'un bouchon sur et/ou dans le trou à une température telle que le clapet d'obturation soit déformé dans une position d'obturation du trou.

La présente invention concerne également un procédé d'encapsulation d'un dispositif microélectronique, comportant la mise en oeuvre d'un procédé de réalisation d'une structure à microcavité tel que décrit ci-dessus, dans lequel le dispositif microélectronique est préalablement disposé sur le substrat ou le premier substrat.

Le procédé d'encapsulation peut être mis en oeuvre de manière collective pour réaliser une encapsulation de plusieurs dispositifs microélectroniques disposés sur le substrat. Les clapets d'obturation peuvent donc également être réalisés de manière collective. Les puces (chaque puce correspond à un ensemble formé d'un dispositif microélectronique et de sa structure d'encapsulation) peuvent ensuite être séparées les unes des autres par une opération de découpe.

Etant donné que les dimensions des trous peuvent être sensiblement plus importantes que dans les procédés de l'art antérieur, la vitesse de libération du dispositif microélectronique, c'est-à-dire la vitesse d'élimination du matériau sacrificiel, peut donc être beaucoup plus importante.

L'étape de bouchage peut correspondre une étape de dépôt par évaporation sous vide du matériau destiné à former le bouchon. Ainsi, il est possible, lorsque le clapet d'obturation est au moins en partie à base d'un matériau getter et/ou qu'un matériau getter est présent dans la microcavité, d'activer le matériau getter préalablement à cette étape de bouchage, notamment par un chauffage réalisé dans la machine de dépôt, favorisant ainsi la désorption des espèces piégées dans la microcavité. Il n'est donc pas nécessaire de procéder à un traitement d'activation thermique du matériau getter postérieurement à la fermeture de la microcavité.

L'étape de bouchage de la microcavité peut être réalisée à une pression telle que la pression régnant dans la microcavité, après sa fermeture, soit inférieure à environ $10^{-3}$ mbar.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- les figures 1, 3 et 4 représentent des structures à microcavités, objets de la présente invention, servant de structure d'encapsulation d'un dispositif microélectronique, respectivement selon un premier, un second et un troisième mode de réalisation,
- les figures 2A à 2F représentent les étapes d'un procédé de réalisation d'une structure à microcavité, objet de la présente invention, correspondant à un procédé d'encapsulation d'un dispositif microélectronique, selon le premier mode de réalisation,
- les figures 5A à 5F représentent les étapes d'un procédé de réalisation d'une structure à microcavité, objet de la présente invention, correspondant à un procédé d'encapsulation d'un dispositif microélectronique, selon le troisième mode de réalisation,
- la figure 6 représente un exemple de clapet d'obturation d'une structure à microcavité, objet de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

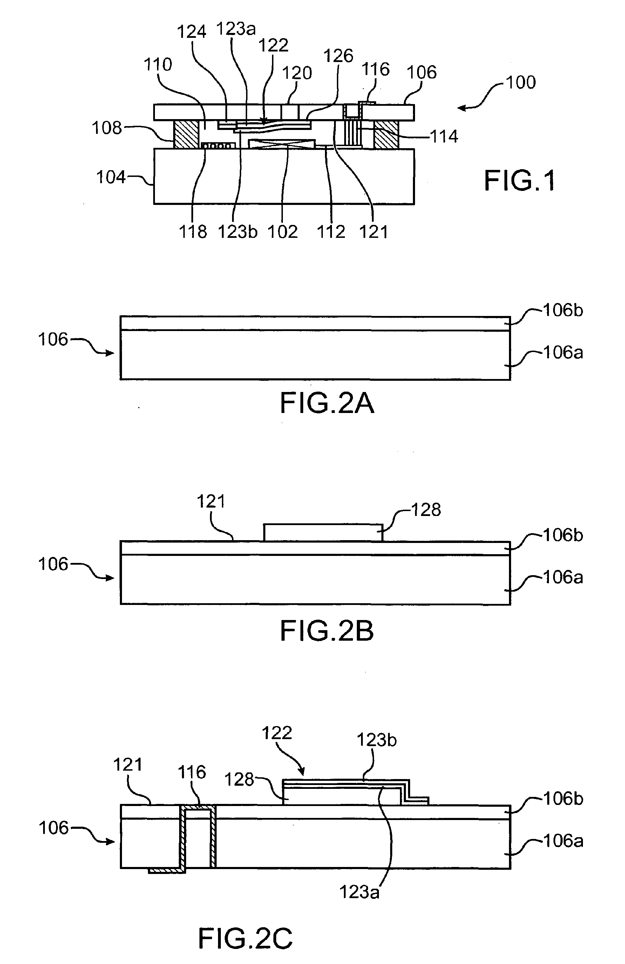

On se réfère tout d'abord à la figure 1 qui représente une structure 100 à microcavité, qui est ici une structure d'encapsulation d'un dispositif microélectronique 102, par exemple de type MEMS et/ou NEMS et/ou MOEMS et/ NOEMS, selon un premier mode de réalisation.

La structure 100 comporte un premier substrat 104, par exemple à base de semi-conducteur tel que du silicium, sur lequel est disposé le dispositif microélectronique 102. La structure 100 comporte également un second substrat 106 formant un capot. Les deux substrats 104 et 106 sont solidarisés par l'intermédiaire d'un cordon de scellement 108, obtenu par exemple par la mise en oeuvre d'un scellement métallique eutectique entre ces deux substrats 104, 106. Le dispositif 102 est ainsi encapsulé dans une microcavité 110 dont les parois sont formées par les deux substrats 104, 106 et par le cordon de scellement 108. Un contact électrique 112 est réalisé dans la microcavité 110 et est relié électriquement au dispositif 102. Un autre contact électrique 116 traverse le second substrat 106 et est relié électriquement au contact électrique 112 par l'intermédiaire d'un via traversant 114, ou plot conducteur. Cet autre contact électrique 116 forme un via traversant le second substrat 106. Les éléments 112, 114 et 116 forment un contact électrique traversant la microcavité 110 depuis le substrat 104 jusqu'au second substrat 106, permettant de relier électriquement le dispositif 102 depuis l'extérieur de la microcavité 110. Un matériau getter 118 est également disposé dans la microcavité 110 afin de réaliser une absorption des gaz présents dans la microcavité 110 et donc de réduire la pression au sein de la microcavité 110.

Un trou de libération 120 est également formé à travers le second substrat 106. Ce trou de libération 120 permet, lors de la réalisation de la structure 100, de supprimer un matériau sacrificiel (référencé 128 sur les figures 2B à 2D) sur lequel est construit un clapet d'obturation 122 et/ou un matériau sacrificiel présent dans la microcavité 110, libérant ainsi le dispositif 102 lorsque celui-ci est construit à l'aide d'un matériau sacrificiel, ce dernier pouvant être différent du matériau sacrificiel utilisé pour la réalisation du clapet 122. Dans une variante, il est possible que plusieurs trous de libération soient réalisés à travers le second substrat 106.

Le clapet d'obturation 122 est disposé au niveau d'une face 121 du second substrat 106 se trouvant à l'intérieur de la microcavité 110, en regard du trou de libération 120. Bien qu'un seul clapet d'obturation 122 soit représenté sur la figure 1, la structure d'encapsulation 100 peut comporter plusieurs clapets d'obturation lorsque plusieurs trous de libération sont formés à travers le second substrat 106. Dans ce cas, il est également possible qu'un ou plusieurs des clapets d'obturation puisse chacun servir à obturer un ou plusieurs trous de libération réalisés à proximité les uns des autres.

Le clapet d'obturation 122 est ici formé par un empilement de deux portions 123a, 123b de matériaux dont les coefficients de dilatation thermique sont différents. Sur l'exemple de la figure 1, le clapet d'obturation 122 est formé par une portion métallique supérieure 123a et une portion métallique inférieure 123b. Le clapet d'obturation 122 est relié mécaniquement au second substrat 106 au niveau d'une première extrémité 124 des deux portions 123a, 123b. Ces deux portions 123a, 123b comportent également une seconde extrémité 126 libre.

Ainsi, compte tenu du fait que les portions 123a, 123b sont à base de matériaux (ici des métaux) de coefficients de dilatation thermique différents, le clapet d'obturation 122 forme donc un bilame apte à se déformer lorsqu'il est soumis à certaines températures. Selon la température à laquelle est soumis le clapet d'obturation 122, celui-ci peut se déformer par une flexion, déplaçant l'extrémité libre 126 vers le haut ou vers le bas, c'est-à-dire dans une position obturant ou non le trou 120. Sur l'exemple de la figure 1, l'extrémité libre 126 est en position haute, le clapet 122 assurant ainsi l'obturation du trou 120. Cette position correspond à celle dans laquelle se trouve le clapet d'obturation 122 lorsqu'il n'est pas sollicité, c'est-à-dire à température ambiante.

Le sens d'actionnement du clapet d'obturation 122 peut être ajusté en jouant sur les coefficients de dilation thermique des portions métalliques 123a, 123b du clapet 122, mais aussi sur les contraintes résiduelles auxquelles les portions 123a, 123b du clapet d'obturation 122 sont soumises après leur réalisation. En effet, les contraintes résiduelles peuvent être telles que le clapet d'obturation 122 soit fléchi vers le haut de la microcavité 110, c'est-à-dire vers le second substrat 106, lorsqu'il est libéré du matériau sacrificiel présent dans la microcavité 110 et placé à température ambiante, comme représenté sur la figure 1. De plus, selon l'intensité de ces contraintes résiduelles, l'obturation peut être hermétique ou non. Lorsque le clapet 122 obture le trou 120, il est possible de fermer hermétiquement la microcavité 110 par un dépôt de matériau de bouchage sur le second substrat 106, au niveau du trou de libération 120, et/ou dans le trou de libération 120.

On se réfère maintenant aux figures 2A à 2F qui représentent les étapes d'un procédé de réalisation de la structure 100, correspondant à un procédé d'encapsulation du dispositif microélectronique 102.

Comme représenté sur la figure 2A, on réalise tout d'abord le second substrat 106 en déposant une couche diélectrique 106b, par exemple à base de SiO$_2$, sur une couche 106a à base de semi-conducteur, par exemple du silicium.

On dépose ensuite sur la face 121 du second substrat 106 une couche sacrificielle, par exemple à base de résine. Cette couche sacrificielle est mise en forme par photolithographie, gravure et éventuellement fluage, formant une portion 128 de matériau sacrificielle, par exemple de la résine (voir figure 2B).

Comme représenté sur la figure 2C, on réalise ensuite le clapet d'obturation 122 en déposant une première couche à base du métal de la portion 123a et en gravant cette première couche pour former la portion 123a. Une seconde couche métallique est ensuite déposée et gravée pour former la portion 123b. Dans l'exemple décrit ici, le coefficient de dilatation thermique du métal de la portion 123a est plus petit que le coefficient de dilatation thermique du métal de la portion 123b. Le contact électrique 116 est également réalisé à travers le second substrat 106.

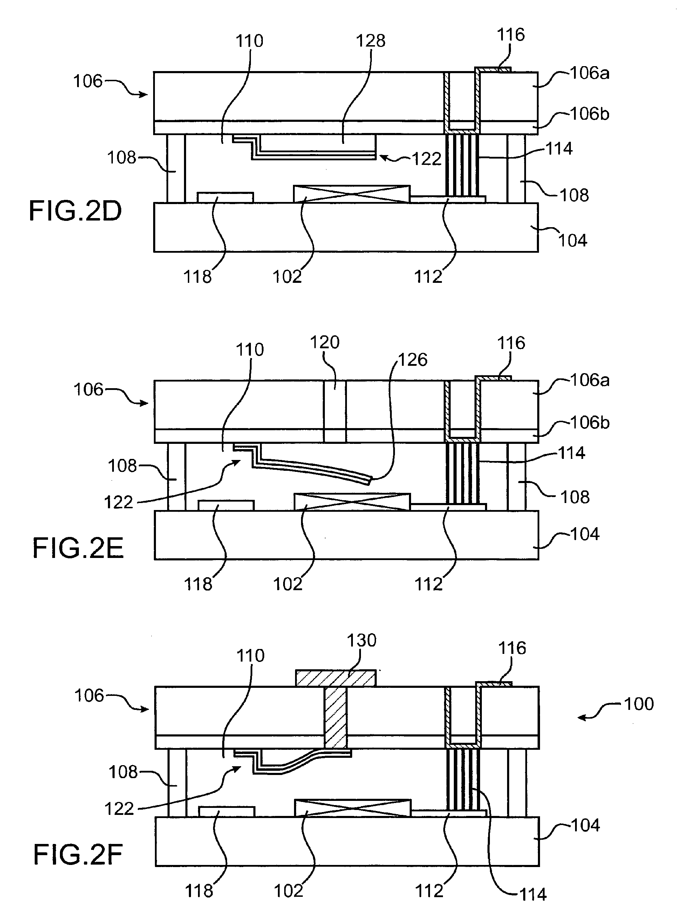

On réalise ensuite la solidarisation du second substrat 106 au premier substrat 104 par l'intermédiaire du cordon de scellement 108 obtenu par exemple par la mise en oeuvre d'un scellement métallique eutectique. Dans ce mode de réalisation, le via 114 reliant électriquement les contacts 112 et 116 est également réalisé, par exemple à partir du même matériau que celui utilisé pour réaliser le cordon de scellement 108. On réalise ensuite un amincissement de la couche 106a du second substrat 106 (figure 2D).

On réalise ensuite, par photolithographie et gravure à travers le second substrat 106, le trou de libération 120. Le clapet d'obturation 122 est ensuite libéré en gravant la portion de résine 128 par voie sèche et à une température telle que l'extrémité libre 126 du clapet 122 fléchisse vers le bas, vers le dispositif microélectronique 102 (figure 2E). Dans cette position, le clapet 122 d'obture pas le trou 120.

Enfin, comme représenté sur la figure 2F, la structure 100 est ramenée à température ambiante. Le clapet d'obturation 122 vient alors obturer l'accès à la microcavité 110 formé par le trou 120, l'extrémité libre 126 fléchissant vers le haut (vers le second substrat 106). On réalise alors le bouchage du trou 120 par un dépôt métallique 130, par exemple de type PVD (dépôt physique en phase vapeur), notamment dans le trou 120..

Le bouchage du trou de libération 120 est obtenu par un dépôt, avantageusement assez directionnel et de type métallique, sur le second substrat 106, au niveau du trou de libération 120. Par exemple, un dépôt métallique par voie PVD permet ainsi de fermer la microcavité 110 de façon hermétique. De plus, selon la pression associée au dépôt de type PVD, il est possible de contrôler la pression résiduelle présente dans la microcavité 110 après sa fermeture hermétique. Ainsi, il est possible de réaliser un dépôt par évaporation sous vide poussé du bouchon 130, ce qui permet d'obtenir un niveau de vide final dans la microcavité inférieur à celui obtenu par un procédé par pulvérisation. Ce dernier mode de réalisation permet éventuellement de contrôler une pression partielle résiduelle de gaz noble (argon, krypton) mise en jeu au cours du procédé de dépôt puisque ce gaz n'est pas absorbé par les matériaux getters.

Dans l'exemple de réalisation précédemment décrit en liaison avec la figure 1 et les figures 2A à 2F, un matériau getter 118 est présent dans la microcavité 110 à côté du dispositif microélectronique 102. Lorsque ce matériau getter n'est pas présent dans la microcavité 110, ou lorsque l'on souhaite réaliser une absorption gazeuse importante, le clapet d'obturation 122 peut comporter au moins une de ses portions métalliques 123a ou 123b, de préférence au moins celle se trouvant en regard du dispositif 102 (c'est-à-dire la portion inférieure 123b sur l'exemple de la figure 1), à base d'un métal présentant un effet getter, contribuant ainsi à gérer la pression finale dans la microcavité 110 renfermant le dispositif 102. A titre d'exemple, un procédé de fermeture par dépôt PVD d'un matériau de bouchage par évaporation sous vide va permettre dans un premier temps, et sous l'action d'une montée en température, de fléchir le clapet d'obturation 122 vers le bas de la microcavité 110, c'est-à-dire vers le dispositif 102, favorisant ainsi l'évacuation des espèces dégazées depuis la microcavité 110. Après refroidissement, le clapet d'obturation 122 peut fléchir vers le haut, en direction du trou de libération 120, favorisant ainsi la fermeture du trou de libération 120 par un dépôt réalisé à température ambiante. De plus, sous l'action de la température et du vide secondaire, le matériau getter (du clapet 122 et/ou de la portion 118) sera alors activé sans qu'une étape d'activation supplémentaire soit nécessaire après le bouchage du trou de libération 120.

Le dimensionnement du clapet d'obturation 122 peut être réalisé de la façon décrite dans le document « Pyromètres à bilames » de J. Jouanneau, Techniques de l'Ingénieur, R 2540-1 à R 2540-10, et qui est résumée ci-dessous :

- l'expression analytique du déplacement D de l'extrémité libre 126 du clapet 122 peut être obtenue à partir des équations suivantes :

$$V = 3/2.(\alpha_2 - \alpha_1).(1 + (E_1.e_1^2 - E_2.e_2^2)^2 / 4.E_1.e_1.E_2.e_2.e^2)^{-1} \qquad (1)$$

$$V/2 = D.e/((L^2 + D^2 - D.e).(T - T_0)) \qquad (2)$$

$$e = e_1 + e_2 \qquad (3)$$

Avec :

$E_i$, $\alpha_i$, $e_i$ : respectivement le module d'Young (Mpa), le coefficient de dilatation thermique (°C$^{-1}$) et l'épaisseur (en m) de la $i^{ème}$ couche métallique du clapet 122,
L : la longueur du clapet 122 (m),
$T_0$ : la température (°C) à laquelle le clapet 122 est horizontal,
T : la température (°C) d'actionnement du clapet 122.

Le tableau suivant indique plusieurs métaux pouvant être utilisés pour réaliser les portions 123a, 123b du clapet d'obturation 122, ainsi que les valeurs des coefficients de dilatation thermique et des modules d'Young de ces matériaux :

| Métal | $\alpha$ (10$^{-6}$/°C) | E (Gpa) |
|-------|-------------------------|---------|
| Al | 23,1 | 70 |
| Cu | 16,5 | 130 |
| Ni | 13,4 | 200 |
| Pt | 8,8 | 168 |

(suite)

| Métal | $\alpha$ ($10^{-6}$/°C) | E (Gpa) |
|-------|------------------------|---------|
| Ti | 8,6 | 116 |
| Zr | 5,7 | 68 |

Pour que le clapet d'obturation 122 se déplace vers le bas (vers le dispositif 102) lors d'une montée en température, le métal de la portion 123a supérieure du clapet 122, c'est-à-dire celle se trouvant du côté du second substrat 106, doit avoir un coefficient de dilatation thermique supérieur à celui du métal de la portion se trouvant du côté du dispositif 102 (portion inférieure 123b sur l'exemple de la figure 1). Il est de plus possible de réaliser des clapets d'obturation 122 à effet getter en réalisant la couche supérieure 123a à partir d'aluminium et/ou de cuivre et/ou de nickel et/ou de platine, et la couche inférieure 123b à partir de titane et/ou de zirconium (le titane et le zirconium étant des métaux présentant un effet getter).

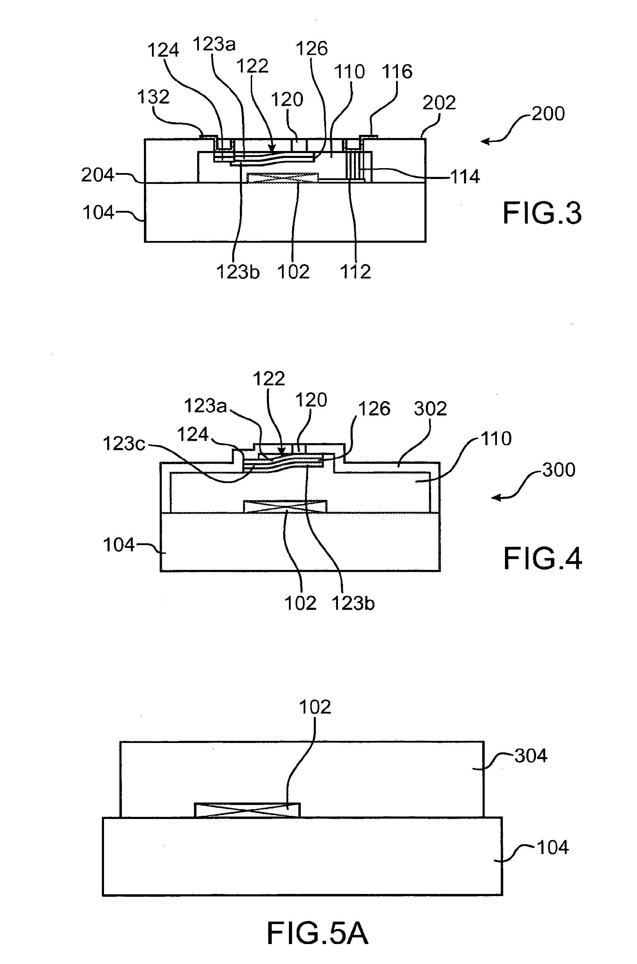

On se réfère à la figure 3 qui représente une structure 200 à microcavité, servant de structure d'encapsulation du dispositif microélectronique 102, selon un second mode de réalisation.

Par rapport à la structure d'encapsulation 100 représentée sur la figure 1, la structure 200 comporte un second substrat 202, par exemple à base de semi-conducteur tel que du silicium, formant un capot et solidarisé au premier substrat 104 par scellement direct au niveau d'une interface 204. Dans ce second mode de réalisation, la structure 200 ne comporte pas de cordon de scellement entre les deux substrats 104, 202. De plus, dans ce second mode de réalisation, le matériau getter 118 n'est pas présent dans la microcavité 110. L'extrémité fixe 124 du clapet d'obturation 122 est reliée électriquement à un contact électrique 132. Ainsi, le clapet d'obturation 122 peut être actionné par un chauffage par effet Joule obtenu par l'intermédiaire d'un courant électrique appliqué sur le contact électrique 132. De plus, lorsque le clapet 122 comporte une de ces portions 123a, 123b à base d'un matériau getter, cet effet Joule permet également de réaliser une activation thermique de ce matériau getter.

Le procédé de réalisation de cette structure 200 est similaire à celui de la structure 100, excepté pour la solidarisation du second substrat 202 au premier substrat 104 qui est réalisée ici par un scellement direct entre les deux substrats 104, 202.

Une structure 300 à microcavité, formant une structure d'encapsulation du dispositif microélectronique 102, selon un troisième mode de réalisation, est représentée sur la figure 4.

Par rapport aux structures d'encapsulation 100 et 200 précédemment décrites en liaison avec les figures 1 et 3, le capot de la microcavité 110 n'est pas réalisé en solidarisant deux substrats entre eux, mais est formé par une couche mince 302 à laquelle le clapet d'obturation 122 est relié mécaniquement. Cette couche mince 302 est par exemple à base d'un oxyde, par exemple du $SiO_2$, et/ou de nitrure, par exemple du SiN. De plus, le clapet d'obturation 122 est ici formé par un empilement de trois portions 123a, 123b et 123c de matériaux dont les coefficients de dilatation thermiques sont différents les uns des autres. Ainsi, le matériau de la portion 123c disposée entre les deux portions 123a et 123b a un coefficient de dilatation thermique supérieur à celui du matériau de la portion 123b se trouvant du côté du dispositif 102 et inférieur à celui du matériau de la portion 123a se trouvant du côté du trou de libération 120. La portion intermédiaire 123c permet de réduire les effets de cisaillement pouvant apparaitre lors de la déformation du clapet 122.

On se réfère aux figures 5A à 5F qui représentent les étapes d'un procédé de réalisation de la structure à microcavité 300.

Comme représenté sur la figure 5A, on réalise tout d'abord le dépôt d'une couche sacrificielle 304 sur le substrat 104, recouvrant le dispositif microélectronique 102 disposé sur le substrat 104. Le dispositif microélectronique 102 peut être réalisé selon des procédés mettant en jeu des matériaux sacrificiels qui pourront être gravés en même temps ou après la couche sacrificielle 304. Cette couche sacrificielle 304 est par exemple à base de résine photosensible, par exemple une résine de polarité positive ou du polyimide. La couche sacrificielle 304 est ensuite mise en forme par photolithographie et gravure afin que son volume corresponde à une partie du volume de la future microcavité 110 de la structure 300. La couche sacrificielle 304 subie également un traitement thermique en vue de la rendre apte à supporter les étapes technologiques suivantes du procédé.

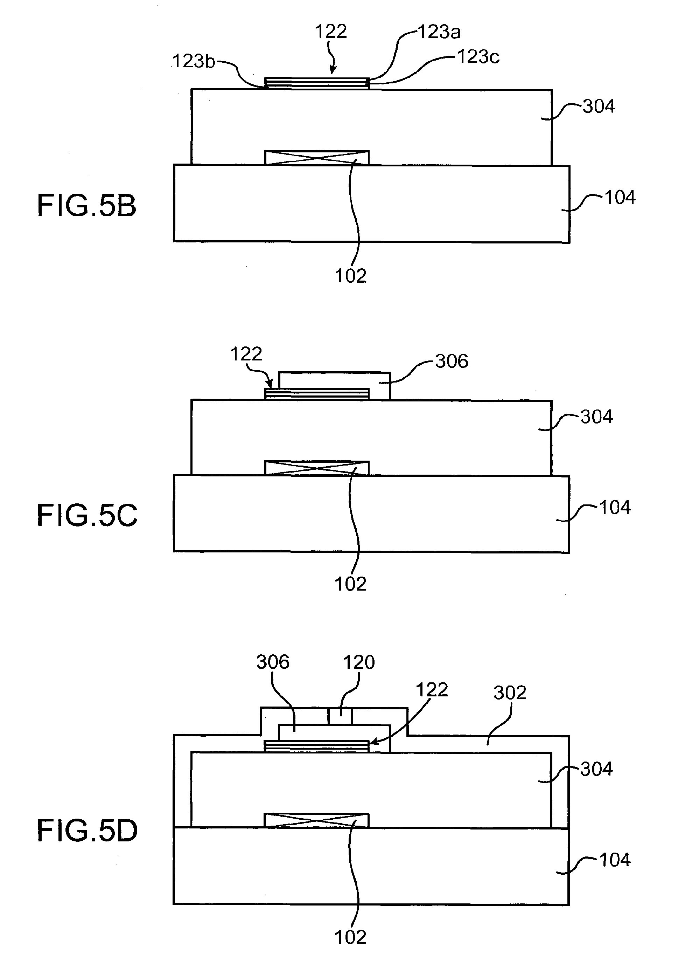

On réalise ensuite le dépôt d'un empilement de trois couches métalliques destinées à former, après mise en forme par photolithographie et gravure, les portions 123a, 123b, 123c métalliques du clapet 122 (figure 5B).

Comme représenté sur la figure 5C, une seconde couche de matériau sacrificiel 306 est déposée puis mise en forme par photolithographie et gravure afin de former une portion sacrificielle 306 destinée à former une partie de la microcavité 110 dans laquelle le clapet 122 se déformera pour venir obturer le trou de libération 120. La portion sacrificielle 306 est par exemple à base du même matériau que celui utilisé pour réaliser la couche sacrificielle 304.

La couche mince 302 destinée à former le capot de la structure 300 est ensuite déposée afin de recouvrir la couche sacrificielle 304, le clapet 122 et la portion sacrificielle 306. Le trou de libération 120 est également réalisé par photolithographie et gravure à travers la couche capot 302 (figure 5D). Il serait également possible, à ce stade du procédé, de réaliser d'autres trous à travers la couche capot 302 pour accéder à des via électriques reliés au dispositif microélectronique 102. Ces via pourront être réalisés avant le dépôt de la couche sacrificielle 304 sur le substrat 104, et remontés du substrat 104 vers la couche capot 302 pour étayer mécaniquement la couche capot 302.

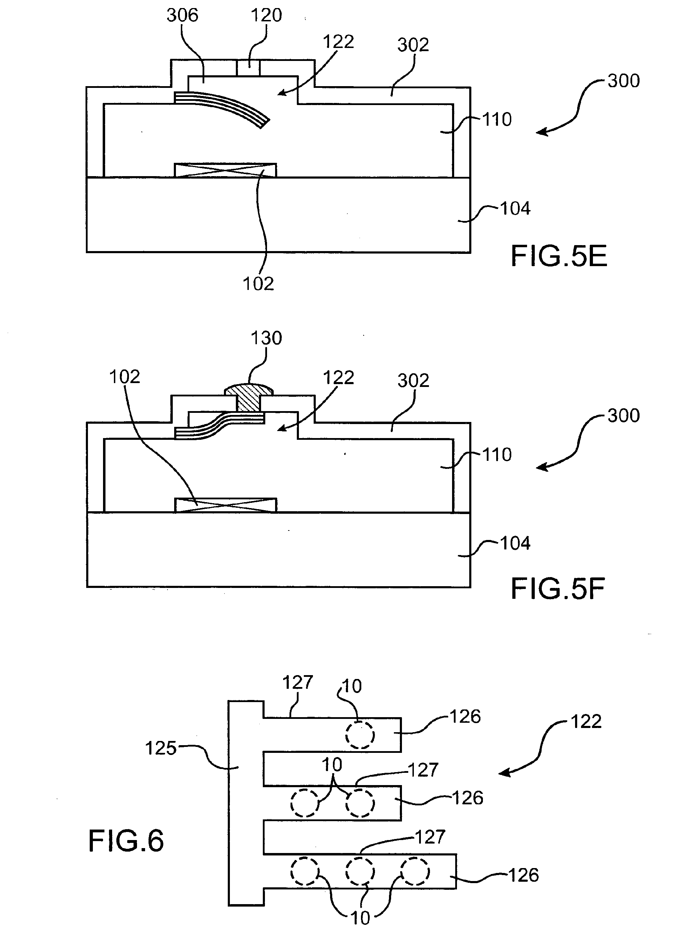

Comme représenté sur la figure 5E, on libère alors le clapet d'obturation 122 en gravant la portion sacrificielle 306 et la couche sacrificielle 304. La température lors de cette gravure est telle que le clapet est fléchi vers le bas (vers le dispositif 102 disposé au fond de la microcavité 110).

Enfin, après un retour à la température ambiante, le clapet 122 prend alors sa position d'obturation du trou 120, ce qui permet de réaliser le bouchage du trou par la réalisation du bouchon 130 sans polluer l'intérieur de la microcavité 110 (figure 5F).

Dans les exemples décrits précédemment, le clapet 122 comporte un seul élément déformable formé par l'empilement de portions 123a, 123b et éventuellement 123c. Dans une variante, il est possible que le clapet d'obturation comporte plusieurs éléments déformables distincts les uns des autres. Un tel clapet 122 est représenté sur la figure 6. Sur cet exemple, le clapet 122 comporte plusieurs éléments déformables 127 formés par des portions de matériaux similaires aux portions 123a, 123b (et éventuellement 123c) des clapets précédemment décrits. Des cercles pointillés 10 représentent symboliquement les trous qui pourront être obturés par les différents éléments déformables 127. On voit donc que chaque élément déformable 127 peut obturer un nombre différent de trous. De plus, le clapet 122 comporte une armature 125 à laquelle tous les éléments déformables 127 sont reliés et qui formera l'extrémité fixe du clapet 122. Une telle armature 125 permettra en outre de consolider mécaniquement le capot de la microcavité. Enfin, chacun des éléments déformables 127 comporte une extrémité libre 126 qui ne sera pas reliée mécaniquement au capot de la structure à microcavité.

Il est possible d'évaluer analytiquement les avantages de l'utilisation du clapet d'obturation 122 lors de la libération du dispositif 102 par rapport à un procédé d'encapsulation selon l'art antérieur tel que décrit précédemment. En effet appelons :

- d, le diamètre d'un trou de libération réalisé au cours du procédé de l'art antérieur,
- n, le nombre de trou de libération réalisés au cours du procédé de l'art antérieur,
- $d_i$, le diamètre d'un trou de libération 120,
- x, la distance du centre du trou 120 par rapport à l'extrémité encastrée 124 du clapet 122 et selon la longueur L du clapet 122,
- D le déplacement de l'extrémité libre 126 du clapet 122.

En faisant l'approximation d'une déformation linéaire du clapet 122, le rapport entre les surfaces de libération calculées selon l'art antérieur et l'une des structures 100, 200 ou 300, permet de définir le nombre n de trous équivalents par l'expression suivante :

$$n = 4.x.D.d_i / (L.d^2) \qquad\qquad (4)$$

Dans le cas d'un clapet situé à l'aplomb d'un ensemble de k trous de libération de diamètre $d_i$ et de coordonnée $x_j$, la formule devisent :

$$n = 4.(x_1 + x_2 + ... + x_k).D.d_i / (L.d^2) \qquad (5)$$

Dans le cas d'un ensemble de k bilames identiques et situés chacun à l'aplomb d'un trou de libération de diamètre $d_i$, l'équation devient :

$$n = 4.k.x.D.d_i / (L.d^2) \qquad\qquad (6)$$

Selon le dispositif à encapsuler et les dimensions de la microcavité, il est donc possible de combiner des clapets de géométries différentes et donc de combiner les équations 5 et 6.

A titre d'application numérique, les équations on été résolues pour le cas d'un clapet 122 de longueur égale à 100 $\mu$m, de largeur égale à 30 $\mu$m, constitué de portions 123a, 123b à base de nickel et de titane. L'épaisseur de chaque portion 123a, 123b est égale à 0,5 $\mu$m. Le diamètre du trou de libération 120 est de 20 $\mu$m. La valeur de x est de 70$\mu$m et celle de d est de 3 $\mu$m. La variation de température est de 100°C. Dans ce cas n vaut environ 21.

**Revendications**

1.  Structure (100, 200, 300) à microcavité (110) comportant au moins :

    - un substrat (104),
    - un capot (106, 202, 302) solidarisé au substrat (104) tel qu'un espace formé entre le capot (106, 202, 302) et le substrat (104) forme la microcavité (110),
    - au moins un trou (120) traversant le capot (106, 202, 302), et
    - au moins un clapet d'obturation (122) du trou (120) disposé à l'intérieur de la microcavité (110) et comprenant au moins deux portions (123a, 123b, 123c) de matériaux de coefficients de dilatation thermique différents disposées l'une contre l'autre, au moins une première extrémité (124, 125) desdites deux portions (123a, 123b, 123c) étant reliée mécaniquement au capot (106, 202, 302), au moins une seconde extrémité (126) desdites deux portions étant libre, et au moins une partie du clapet d'obturation (122) étant disposée en regard du trou (120), lesdites deux portions (123a, 123b, 123c) étant aptes à obturer ou non le trou (120) sous l'effet d'une variation de température.

2.  Structure (100, 200) selon la revendication 1, dans laquelle le capot comporte un second substrat (106, 202) solidarisé directement, ou par l'intermédiaire d'un cordon de scellement (108), à l'autre substrat (104) appelé premier substrat.

3.  Structure (300) selon la revendication 1, dans laquelle le capot comporte une couche (302) de matériau d'épaisseur comprise entre environ 1 $\mu$m et 10 $\mu$m.

4.  Structure (100, 200, 300) selon l'une des revendications précédentes, dans laquelle les dimensions du trou (120) sont comprises entre environ 1 $\mu$m et 100 $\mu$m.

5.  Structure (100, 200, 300) selon l'une des revendications précédentes, dans laquelle au moins une (123b) desdites deux portions de matériaux de coefficients de dilatation thermique différents est à base d'un matériau getter.

6.  Structure (300) selon l'une des revendications précédentes, dans laquelle le clapet d'obturation (122) comporte au moins trois portions (123a, 123b, 123c) de matériaux de coefficients de dilatation thermique différents, la valeur du coefficient de dilatation thermique du matériau de la portion (123c) disposée entre les deux autres (123a, 123b) étant comprise entre les valeurs des coefficients de dilatation thermique des matériaux desdites deux autres portions (123a, 123b) de matériaux.

7.  Structure selon l'une des revendications précédentes, dans laquelle lesdites au moins deux portions (123a, 123b, 123c) de matériaux de coefficients de dilatation thermique différents forment plusieurs éléments déformables (127), au moins une première extrémité de chaque élément déformable (127) étant reliée mécaniquement au capot (106, 108, 202, 302) par l'intermédiaire d'au moins un élément non déformable, au moins une seconde extrémité (126) de chaque élément déformable (127) étant libre, et au moins une partie de chaque élément déformable (127) étant disposée en regard d'au moins un trou (120) traversant le capot (106, 202, 302).

8.  Structure (200) selon l'une des revendications précédentes, comportant en outre au moins un contact électrique (132) traversant le capot (202) et relié électriquement au clapet d'obturation (122).

9.  Structure (100, 200) selon l'une des revendications précédentes, comportant en outre au moins un contact électrique (112, 114, 116) traversant la microcavité (110) depuis le substrat (104) jusqu'au capot (106, 202).

10. Structure (100, 200, 300) selon l'une des revendications précédentes, comportant en outre au moins un bouchon (130) bouchant le trou (120).

11. Structure (100, 200, 300) d'encapsulation d'un dispositif microélectronique (102), dans laquelle le dispositif micro-électronique (102) est disposé dans la microcavité (110) d'une structure (100, 200, 300) selon l'une des revendications précédentes.

12. Procédé de réalisation d'une structure (100, 200) à microcavité (110), comportant au moins les étapes de :

    - réalisation d'une portion (128) de matériau sacrificiel sur un second substrat (106) ;
    - réalisation d'au moins deux portions (123a, 123b, 123c) de matériaux de coefficients de dilatation thermique différents disposées l'une contre l'autre et en partie sur la portion (128) de matériau sacrificiel telles qu'au moins une première extrémité (124) desdites deux portions (123a, 123b, 123c) soit disposée sur le second substrat (106) et au moins une seconde extrémité (126) desdites deux portions soit disposée sur la portion (128) de matériau sacrificiel ;

- solidarisation du second substrat (106) à un premier substrat (104) telle qu'un espace entre le second substrat (106) et le premier substrat (104) forme la microcavité (110) ;

- réalisation d'au moins un trou (120) à travers le second substrat (106), formant un accès à la portion (128) de matériau sacrificiel ;

- élimination de la portion (128) de matériau sacrificiel à travers le trou (120), lesdites deux portions (123a, 123b, 123c) de matériaux de coefficients de dilatation thermique différents formant un clapet d'obturation (122) du trou (120) tel que lesdites deux portions (123a, 123b, 123c) sont aptes à obturer ou non le trou (120) sous l'effet d'une variation de température.

**13.** Procédé de réalisation d'une structure (300) à microcavité (110), comportant au moins les étapes de :

- dépôt d'une couche (304) de matériau sacrificiel sur un substrat (104) ;
- mise en forme de la couche (304) de matériau sacrificiel ;
- réalisation d'au moins deux portions (123a, 123b, 123c) de matériaux de coefficients de dilatation thermique différents disposées l'une contre l'autre sur la couche (304) de matériau sacrificiel ;
- réalisation d'une portion (306) de matériau sacrificiel disposée en partie sur lesdites deux portions (123a, 123b, 123c) de matériaux de coefficients de dilatation thermique différents et sur la couche (304) de matériau sacrificiel ;
- dépôt d'une couche capot (302) recouvrant la couche (304) de matériau sacrificiel, lesdites deux portions (123a, 123b, 123c) de matériaux de coefficients de dilatation thermique différents et la portion (306) de matériau sacrificiel ;
- réalisation d'au moins un trou (120) à travers la couche capot (302), formant un accès à la portion (306) de matériau sacrificiel ;
- élimination de la portion (306) et de la couche (304) de matériau sacrificiel à travers le trou (120), formant la microcavité (110), lesdites deux portions (123a, 123b, 123c) de matériaux de coefficients de dilatation thermique différents formant un clapet d'obturation (122) du trou (120) tel que lesdites deux portions (123a, 123b, 123c) sont aptes à obturer ou non le trou (120) sous l'effet d'une variation de température.

**14.** Procédé selon l'une des revendications 12 ou 13, dans lequel l'étape d'élimination de la portion (128) de matériau sacrificiel, ou de la portion (306) et de la couche (304) de matériau sacrificiel, est mise en oeuvre à une température telle que le clapet d'obturation (122) soit déformé dans une position n'obturant pas le trou (120).

**15.** Procédé selon l'une des revendications 12 à 14, comportant en outre, après l'étape d'élimination de la portion (128) de matériau sacrificiel, ou de la portion (306) et de la couche (304) de matériau sacrificiel, une étape de bouchage de la microcavité (110) par la réalisation d'un bouchon (130) sur et/ou dans le trou (120) à une température telle que le clapet d'obturation (122) soit déformé dans une position d'obturation du trou (120).

**16.** Procédé d'encapsulation d'un dispositif microélectronique (102), comportant la mise en oeuvre d'un procédé de réalisation d'une structure (100, 200, 300) à microcavité (110) selon l'une des revendications 12 à 15, dans lequel le dispositif microélectronique (102) est préalablement disposé sur le substrat (104) ou le premier substrat (104).

## Patentansprüche

**1.** Struktur (100, 200, 300) mit einer Mikrokavität (110), umfassend wenigstens:

- ein Substrat (104),
- einen Deckel (106, 202, 302), der mit dem Substrat (104) derart verbunden ist, dass ein zwischen dem Deckel (106, 202, 302) und dem Substrat (104) gebildeter Raum die Mikrokavität (110) bildet,
- wenigstens ein Loch (120), das den Deckel (106, 202, 302) durchsetzt, und
- wenigstens eine Klappe (122) zum Verschließen des Lochs (120), die im Inneren der Mikrokavität (110) angeordnet ist und wenigstens zwei Bereiche (123a, 123b, 123c) aus Materialien mit unterschiedlichen thermischen Ausdehnungskoeffizienten umfaßt, die gegeneinander angeordnet sind, wobei wenigstens ein erstes Ende (124, 125) der zwei Bereiche (123a, 123b, 123c) mechanisch mit dem Deckel (106, 202, 302) verbunden ist, wobei wenigstens ein zweites Ende (126) der zwei Bereiche frei ist, und wobei wenigstens ein Teil der Verschlußklappe (122) gegenüber dem Loch (120) angeordnet ist, wobei die zwei Bereiche (123a, 123b, 123c) dazu ausgelegt sind, das Loch (120) unter Einwirkung einer Temperaturveränderung wohl oder nicht zu verschließen.

2. Struktur (100, 200) nach Anspruch 1, bei der der Deckel ein zweites Substrat (106, 202) umfaßt, welches direkt oder mittels eines Kopplungsgurts (108) mit dem anderen Substrat (104), genannt erstes Substrat, verbunden ist.

3. Struktur (300) nach Anspruch 1, bei der der Deckel eine Schicht (302) aus Material mit einer Dicke umfaßt, die zwischen ungefähr 1 μm und 10 μm enthalten ist.

4. Struktur (100, 200, 300) nach einem der vorhergehenden Ansprüche, bei der die Abmessungen des Lochs (120) zwischen ungefähr 1 μm und 100 μm enthalten sind.

5. Struktur (100, 200, 300) nach einem der vorhergehenden Ansprüche, bei der wenigstens einer (123b) der zwei Bereiche aus Materialien mit unterschiedlichen thermischen Ausdehnungskoeffizienten auf Basis eines Gettermaterials hergestellt ist.

6. Struktur (300) nach einem der vorhergehenden Ansprüche, bei der die Verschlußklappe (122) wenigstens drei Bereiche (123a, 123b, 123c) aus Materialien mit unterschiedlichen thermischen Ausdehnungskoeffizienten umfaßt, wobei der Wert des thermischen Ausdehnungskoeffizienten des Materials des Bereichs (123c), der zwischen den zwei anderen (123a, 123b) angeordnet ist, zwischen den Werten der thermischen Ausdehnungskoeffizienten der Materialien der zwei anderen Materialbereiche (123a, 123b) enthalten ist.

7. Struktur nach einem der vorhergehenden Ansprüche, bei der die wenigstens zwei Bereiche (123a, 123b, 123c) aus Materialien mit unterschiedlichen thermischen Ausdehnungskoeffizienten mehrere verformbare Elemente (127) bilden, wobei wenigstens ein erstes Ende jedes verformbaren Elements (127) mechanisch mittels wenigstens eines nicht verformbaren Elements mit dem Deckel (106, 108, 202, 302) verbunden ist, wobei wenigstens ein zweites Ende (126) jedes verformbaren Elements (127) frei ist, und wobei wenigstens ein Teil jedes verformbaren Elements (127) gegenüber wenigstens einem Loch (120) angeordnet ist, das den Deckel (106, 202, 302) durchsetzt.

8. Struktur (200) nach einem der vorhergehenden Ansprüche, ferner umfassend wenigstens einen elektrischen Kontakt (132), der den Deckel (202) durchsetzt und elektrisch mit der Verschlußklappe (122) verbunden ist.

9. Struktur (100, 200) nach einem der vorhergehenden Ansprüche, ferner umfassend wenigstens einen elektrischen Kontakt (112, 114, 116), der die Mikrokavität (110) ausgehend vom Substrat (104) bis zum Deckel (106, 202) durchsetzt.

10. Struktur (100, 200, 300) nach einem der vorhergehenden Ansprüche, ferner umfassend wenigstens einen Stöpsel (130), der das Loch (120) verstopft.

11. Struktur (100, 200, 300) zur Einkapselung einer mikroelektronischen Vorrichtung (102), bei der die mikroelektronische Vorrichtung (102) in der Mikrokavität (110) einer Struktur (100, 200, 300) nach einem der vorhergehenden Ansprüche angeordnet ist.

12. Verfahren zur Herstellung einer Struktur (100, 200) mit einer Mikrokavität (110), umfassend wenigstens die folgenden Schritte:

- Realisieren eines Bereichs (128) aus Opfermaterial auf einem zweiten Substrat (106);
- Realisieren von wenigstens zwei Bereichen (123a, 123b, 123c) aus Materialien mit unterschiedlichen thermischen Ausdehnungskoeffizienten gegeneinander angeordnet und teilweise auf dem Bereich (128) aus Opfermaterial derart, dass wenigstens ein erstes Ende (124) der zwei Bereiche (123a, 123b, 123c) auf dem zweiten Substrat (106) angeordnet ist und wenigstens ein zweites Ende (126) der zwei Bereiche auf dem Bereich (128) aus Opfermaterial angeordnet ist;
- Verbinden des zweiten Substrats (106) mit einem ersten Substrat (104) derart, dass ein Raum zwischen dem zweiten Substrat (106) und dem ersten Substrat (104) die Mikrokavität (110) bildet;
- Realisieren wenigstens eines Lochs (120) durch das zweite Substrat (106) hindurch, welches einen Zugang zu dem Bereich (128) aus Opfermaterial bildet;

- Entfernen des Bereichs (128) aus Opfermaterial durch das Loch (120) hindurch, wobei die zwei Bereiche (123a, 123b, 123c) aus Materialien mit unterschiedlichen thermischen Ausdehnungskoeffizienten eine Klappe (122) zum Verschließen des Lochs (120) derart bilden, dass die zwei Bereiche (123a, 123b, 123c) dazu ausgelegt sind, das Loch (120) unter Einwirkung einer Temperaturveränderung wohl oder nicht zu verschließen.

13. Verfahren zur Herstellung einer Struktur (300) mit einer Mikrokavität (110), umfassend wenigstens die folgenden Schritte:

- Aufbringen einer Schicht (304) aus Opfermaterial auf einem Substrat (104);
- Formen der Schicht (304) aus Opfermaterial;
- Realisieren von wenigstens zwei Bereichen (123a, 123b, 123c) aus Materialien mit unterschiedlichen thermischen Ausdehnungskoeffizienten gegeneinander angeordnet auf der Schicht (304) aus Opfermaterial;
- Realisieren eines Bereichs (306) aus Opfermaterial teilweise auf den zwei Bereichen (123a, 123b, 123c) aus Materialien mit unterschiedlichen thermischen Ausdehnungskoeffizienten und auf der Schicht (304) aus Opfermaterial angeordnet;
- Aufbringen einer Deckelschicht (302), die die Schicht (304) aus Opfermaterial, die zwei Bereiche (123a, 123b, 123c) aus Materialien mit unterschiedlichen thermischen Ausdehnungskoeffizienten sowie den Bereich (306) aus Opfermaterial bedeckt;
- Realisieren wenigstens eines Lochs (120) durch die Deckelschicht (302) hindurch, das einen Zugang zu dem Bereich (306) aus Opfermaterial bildet;
- Entfernen des Bereichs (306) und der Schicht (304) aus Opfermaterial durch das Loch (120) hindurch zum Bilden der Mikrokavität (110), wobei die zwei Bereiche (123a, 123b, 123c) aus Materialien mit unterschiedlichen thermischen Ausdehnungskoeffizienten eine Klappe (122) zum Verschließen des Lochs (120) derart bilden, dass die zwei Bereiche (123a, 123b, 123c) dazu ausgelegt sind, unter Einwirkung einer Temperaturveränderung das Loch (120) wohl oder nicht zu verschließen.

14. Verfahren nach einem der Ansprüche 12 oder 13, bei dem der Schritt des Entfernens des Bereichs (128) aus Opfermaterial oder des Bereichs (306) und der Schicht (304) aus Opfermaterial bei einer derartigen Temperatur durchgeführt wird, dass die Verschlußklappe (122) in eine Position verformt ist, bei der sie das Loch (120) nicht verschließt.

15. Verfahren nach einem der Ansprüche 12 bis 14, ferner umfassend, nach dem Schritt des Entfernens des Bereichs (128) aus Opfermaterial oder des Bereichs (306) und der Schicht (304) aus Opfermaterial, einen Schritt des Verstopfens der Mikrokavität (110) durch Realisierung eines Stöpsels (130) auf und/oder in dem Loch (120) bei einer derartigen Temperatur, dass die Verschlußklappe (122) in eine Position zum Verschließen des Lochs (120) verformt ist.

16. Verfahren zur Einkapselung einer mikroelektronischen Vorrichtung (102), umfassend die Durchführung eines Verfahrens zur Herstellung einer Struktur (100, 200, 300) mit einer Mikrokavität (110) nach einem der Ansprüche 12 bis 15, bei dem die mikroelektronische Vorrichtung (102) zuvor auf dem Substrat (104) oder dem ersten Substrat (104) angeordnet wird.

**Claims**

1. Microcavity (110) structure (100, 200, 300) comprising at least:

- a substrate (104),
- a cover (106, 202, 302) attached to the substrate (104) such that a space formed between the cover (106, 202, 302) and the substrate (104) forms the microcavity (110),
- at least one hole (120) passing through the cover (106, 202, 302), and
- at least one closing flap (122) of the hole (120) placed inside the microcavity (110) and comprising at least two portions (123a, 123b, 123c) of materials with different thermal expansion coefficients placed one against the other, at least one first end (124, 125) of said two portions (123a, 123b, 123c) being mechanically linked to the cover (106, 202, 302), at least a second end (116) of said two portions being free, and at least a part of the closing flap (122) being placed opposite the hole (120), said two portions (123a, 123b, 123c) being capable of closing or not the hole (120) under the effect of a temperature variation.

2. Structure (100, 200) according to claim 1, in which the cover comprises a second substrate (106, 202) attached directly, or via a sealing cord (108), to the other substrate (104) called first substrate.

3. Structure (300) according to claim 1, in which the cover comprises a layer (302) of material with thickness comprised between about 1 μm and 10 μm.

4. Structure (100, 200, 300) according to one of the previous claims, in which the dimensions of the hole (120) are comprised between about 1 μm and 100 μm.

5. Structure (100, 200, 300) according to the previous claims, in which at least one (123b) of said two portions of materials with different thermal expansion coefficients is made of a getter material.

6. Structure (300) according to one of the previous claims, in which the closing flap (122) comprises at least three portions (123a, 123b, 123c) of materials with different thermal expansion coefficients, the value of the thermal expansion coefficient of the material of the portion (123c) placed between the two other portions (123a, 123b) falling between the values of thermal expansion coefficients of the materials of said two other portions (123a, 123b) of materials.

7. Structure according to one of the previous claims, in which said at least two portions (123a, 123b, 123c) of materials with different thermal expansion coefficients form a plurality of deformable elements (127), at least a first end of each deformable element (127) being mechanically linked to the cover (106, 108, 202, 302) via at least one non deformable element, at least a second end (126) of each deformable element (127) being free, and at least a part of each deformable element (127) being placed opposite at least one hole (120) passing through the cover (106, 202, 302).

8. Structure (200) according to one of the previous claims, comprising, in addition, at least one electrical contact (132) passing through the cover (202) and electrically linked to the closing flap (122).

9. Structure (100, 200) according to one of the previous claims, comprising, in addition, at least one electrical contact (112, 114, 116) passing through the microcavity (110) from the substrate (104) to the cover (106, 202).

10. Structure (100, 200, 300) according to one of the previous claims, comprising, in addition, at least one plug (130) plugging the hole (120).

11. Encapsulation structure (100, 200, 300) for a microelectronic device (102), in which the microelectronic device (102) is placed inside the microcavity (110) of a structure (100, 200, 300) according to one of the previous claims.

12. Method for producing a microcavity (110) structure (100, 200), comprising at least the steps of:

   - producing a portion (128) of sacrificial material on a second substrate (106);
   - producing at least two portions (123a, 123b, 123c) of materials with different thermal expansion coefficients placed one against the other and partially on the portion of sacrificial material (128) so that at least a first end (124) of said two portions (123a, 123b, 123c) is placed on the second substrate (106) and at least a second end (126) of said two portions is placed on the portion (128) of sacrificial material;
   - attachment of the second substrate (106) to a first substrate (104) so that a space between the second substrate (106) and the first substrate (104) forms the microcavity (110);
   - producing at least one hole (120) through the second substrate (106), forming an access to the portion (128) of sacrificial material;
   - elimination of the portion (128) of sacrificial material through the hole (120), said two portions (123a, 123b, 123c) of materials with different thermal expansion coefficients forming a closing flap (122) of the hole (120) so that said two portions (123a, 123b, 123c) are capable of closing or not the hole (120) under the effect of a temperature variation.

13. Method for producing a microcavity (110) structure (300), comprising at least the steps of:

   - deposition of a layer (304) of sacrificial material on a substrate (104);
   - shaping the layer (304) of sacrificial material;
   - producing at least two portions (123a, 123b, 123c) of materials with different thermal expansion coefficients placed one against the other on the layer (304) of sacrificial material;

- producing a portion (306) of sacrificial material placed, in part, on said two portions (123a, 123b, 123c) of materials with different thermal expansion coefficients and on the layer (304) of sacrificial material;

- deposition of a cover layer (302) covering the layer (304) of sacrificial material, said two portions (123a, 123b, 123c) of materials with different thermal expansion coefficients and the portion (306) of the sacrificial material;

- producing at least one hole (120) through the cover layer (302), forming an access to the portion (306) of sacrificial material;

- elimination of the portion (306) and of the layer (304) of sacrificial material through the hole (120), forming the microcavity (110), said two portions (123a, 123b, 123c) of materials with different thermal expansion coefficients forming a closing flap (122) of the hole (120) so that said two portions (123a, 123b, 123c) are capable of closing or not the hole (120) under the effect of a temperature variation.

14. Method according to one of the claims 12 or 13, in which the step of elimination of the portion (128) of sacrificial material, or of the portion (306) and of the layer (304) of sacrificial material, is performed at a temperature such that the closing flap is deformed in a position which does not close the hole (120).

15. Method according to one of the claims 12 to 14, comprising, in addition, following the step of elimination of the portion (128) of sacrificial material, or of the portion (306) and of the layer (304) of sacrificial material, a step of plugging the microcavity (110) by the fabrication of a plug (130) on and/or in the hole (120) at a temperature such that the closing flap (122) is deformed in a position of closing the hole (120).

16. Encapsulation method of a microelectronic device (102), comprising the implementation of a method of fabricating a microcavity (110) structure (100, 200, 300) according to one of the claims 12 to 15, in which the microelectronic device (102) is previously placed on the substrate (104) or the first substrate (104).

FIG.1

FIG.2A

FIG.2B

FIG.2C

FIG.2D

FIG.2E

FIG.2F

FIG.3

FIG.4

FIG.5A

FIG.5B

123b — 122 — 123a — 123c

304

104

102

FIG.5C

122 — 306

304

104

102

FIG.5D

306 — 120 — 122 — 302

304

104

102

FIG.5E

FIG.5F

FIG.6

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1708958 B1
- EP 1694597 B1

- US 20090090531 A1